(19) Europäisches Patentamt / European Patent Office / Office européen des brevets

(11) **EP 2 363 961 A1**

(12) **EUROPEAN PATENT APPLICATION**

(43) Date of publication:
07.09.2011   Bulletin 2011/36

(51) Int Cl.:
*H03M 1/12* (2006.01)

(21) Application number: 10275026.2

(22) Date of filing: 04.03.2010

(84) Designated Contracting States:
AT BE BG CH CY CZ DE DK EE ES FI FR GB GR HR HU IE IS IT LI LT LU LV MC MK MT NL NO PL PT RO SE SI SK SM TR
Designated Extension States:
AL BA ME RS

(71) Applicant: BAE SYSTEMS plc
London SW1Y 5AD (GB)

(72) Inventor: **The designation of the inventor has not yet been filed**

(74) Representative: **BAE SYSTEMS plc**
**Group IP Department**
**P.O. Box 87**
**Warwick House**
**Farnborough Aerospace Centre**
**Farnborough**
**Hampshire GU14 6YU (GB)**

(54) **Sampling**

(57)   A method and apparatus for performing sampling, comprising: sampling an input signal (16) using a first sampling signal (22) to provide a first sampled signal (26); sampling the input signal (16) using a second sampling signal (24) to provide a second sampled signal (30); measuring a frequency of one of the first sampled signal (26) and second sampled signal (30); measuring a phase difference between the first and the second sampled signal (26, 30); and determining an input signal frequency using the frequency and the phase difference; wherein the second sampling signal (24) has substantially equal frequency to the first sampling signal (22); and a waveform of the second sampling signal (24) is shifted in time with respect to a waveform of the first sampling signal (22). Measuring a frequency of the first or second sampled signal may be performed within a Nyquist zone of an analogue-to-digital converter (12, 14).

FIG. 1

**Description**

FIELD OF THE INVENTION

The present invention relates to sampling and apparatus for performing sampling.

BACKGROUND

Conventionally, when sampling signals that have a frequency outside the Nyquist bandwidth of an analogue-to-digital converter (ADC) being used to perform the sampling of the signal, more than one such ADC is required to achieve the sampling rate required by the Nyquist sampling theorem. For example, if a sampling rate of 8GHz is required, and the fastest sampling rate that can be achieved by an ADC is 1 GHz, then eight such ADCs are required to achieve the required sampling rate.

However, although the required sampling rate may be achieved, the response of the ADCs, i.e. the bandwidth that the ADCs can respond to, may be too low for the signal being sampled.

SUMMARY OF THE INVENTION

In a first aspect the present invention provides a method of performing sampling, the method comprising sampling an input signal using a first sampling signal to provide a first sampled signal, sampling the input signal using a second sampling signal to provide a second sampled signal, measuring a frequency of at least one of the first sampled signal and the second sampled signal, measuring a phase difference between the first sampled signal and the second sampled signal, and determining a frequency of the input signal using the measured frequency and the measured phase difference, wherein the second sampling signal has substantially equal frequency to the first sampling signal, and a waveform of the second sampling signal is shifted in time with respect to a waveform of the first sampling signal.

The measured frequency of at least one of the first sampled signal and the second sampled signal may be a measured alias frequency of the true frequency of at least one of the first sampled signal and the second sampled signal.

The waveform of the second sampling signal may be substantially equal to the waveform of the first sampling signal.

The method may further comprise the step of determining the amplitude of the input signal using the waveforms and magnitudes of the sampling signals, values of the frequency of the waveforms of the sampling signals, and the determined input signal frequency.

The step of measuring a frequency of at least one of the first sampled signal and the second sampled signal may be performed within a Nyquist zone of an analogue-to-digital converter.

The step of determining a frequency of the input signal may further comprise using a value of a frequency of a sampling signal, a value of the time shift that the second sampling signal is shifted in time relative to the first sampling signal, and a value of the time period of a sampling signal.

The frequency of the input signal may be determined using the following formula:

$$f_{sig} = -1 * Spectral\_index * f_s + Measured\_frequency$$

where: $f_{sig}$ is the frequency of the input signal;

$f_s$ is the frequency of a sampling signal;

Measured_frequency is a measured value of a frequency of at least one of the first sampled signal and the second sampled signal; and

$$Spectral\_index = \frac{Phase\_difference}{Phase\_step\_for\_first\_indexed\_spectral\_line}$$

where: Phase_difference is the measured phase difference; and

Phase_step_for_first_indexed_spectral_line is a value of a phase step of a first spectral line in a frequency spectrum of the sampling signals.

The frequency of the input signal may be determined using the following formula:

$$f_{sig} = -1 * Spectral\_index * f_s + Measured\_frequency$$

where: $f_{sig}$ is the frequency of the input signal;

$f_s$ is the frequency of a sampling signal;

Measured_frequency is a measured value of a frequency of at least one of the first sampled signal and the second sampled signal; and

$$Spectral\_index = Round\left[\frac{Phase\_difference}{Phase\_step\_for\_first\_indexed\_spectral\_line}\right]$$

where: Phase_difference is the measured phase difference; and

Phase_step_for_first_indexed_spectral_line is a value of a phase step of a first spectral line in a frequency spectrum of the sampling signals; and

Round[X] is the value of X rounded to the nearest integer.

Phase_step_for_first_indexed_spectral_line may be given by the following equation:

$$Phase\_step\_for\_first\_indexed\_spectral\_line = -2 \cdot \pi \cdot \frac{t_{sep}}{T}$$

where: $t_{se}p$ is a value of the time shift that the waveform of the second sampling signal is shifted by with respect to the waveform of the first sampling signal; and

T is a value of a time period of a sampling signal.

The step of measuring a frequency of at least one of the first sampled signal and the second sampled signal may comprise filtering the first sampled signal such that it lies within a Nyquist zone of a first analogue-to-digital converter, using the first analogue-to-digital converter, converting to a discrete signal the filtered first sampled signal, filtering the second sampled signal such that it lies within a Nyquist zone of a second analogue-to-digital converter, using the second analogue-to-digital converter, converting to a discrete signal the filtered second sampled signal, and measuring a value of the frequency of signal converted by the first analogue-to-digital converter and/or a value of the frequency of signal converted by the second analogue-to-digital converter.

In a further aspect the present invention provides an apparatus for performing sampling, the apparatus comprising a first sampler adapted to sample an input signal using a first sampling signal to provide a first sampled signal, a second sampler adapted to sample the input signal using a second sampling signal to provide a second sampled signal, means for measuring a frequency of at least one of the first sampled signal and the second sampled signal, means for measuring a phase difference between the first sampled signal and the second sampled signal, and a processor adapted to determine a frequency of the input signal using the measured frequency and the measured phase difference, wherein the second sampling signal has substantially equal frequency to the first sampling signal, and a waveform of the second sampling signal is shifted in time with respect to a waveform of the first sampling signal.

The processor may be adapted to determine a frequency of the input signal using the measured frequency, the measured phase difference, a value of a frequency of a sampling signal, a value of the time shift that the second sampling signal is shifted in time relative to the first sampling signal, and a value of the time period of a sampling signal.

The apparatus may further comprise a first filter, a second filter, a first analogue-to-digital converter, and a second analogue-to-digital converter, wherein the first filter is arranged to filter the first sampled signal such that it lies within a Nyquist zone of the first analogue-to-digital converter, the first analogue-to-digital converter is arranged to convert to a discrete signal the filtered first sampled signal, the second filter is arranged to filter the second sampled signal such that it lies within a Nyquist zone of the second analogue-to-digital converter, the second analogue-to-digital converter is arranged to convert to a discrete signal the filtered second sampled signal; and the means for measuring a frequency of at least one of the first sampled signal and the second sampled signal is adapted to measure a value of the frequency of signal converted by the first analogue-to-digital converter and/or a value of the frequency of signal converted by the second analogue-to-digital converter.

In a further aspect the present invention provides computer program or plurality of computer programs arranged such that when executed by a computer system it/they cause the computer system to operate in accordance with the method of any of the above aspects.

In a further aspect the present invention provides a machine readable storage medium storing a computer program or at least one of the plurality of computer programs according to the above aspect.

BRIEF DESCRIPTION OF THE DRAWINGS

Figure 1 is a schematic block diagram of an apparatus used in an embodiment of an offset sampling process;

Figure 2 is a process flow chart showing certain steps of an embodiment of the offset sampling process;

Figure 3 is a schematic illustration showing a first sampling signal and a second sampling signal in the time domain;

Figure 4 is a schematic illustration showing the first sampling signal in the frequency domain;

Figure 5 is a schematic illustration of the frequency spectrum of an output signal; and

Figure 6 is a schematic illustration of the frequency spectrum of a filtered output signal.

DETAILED DESCRIPTION

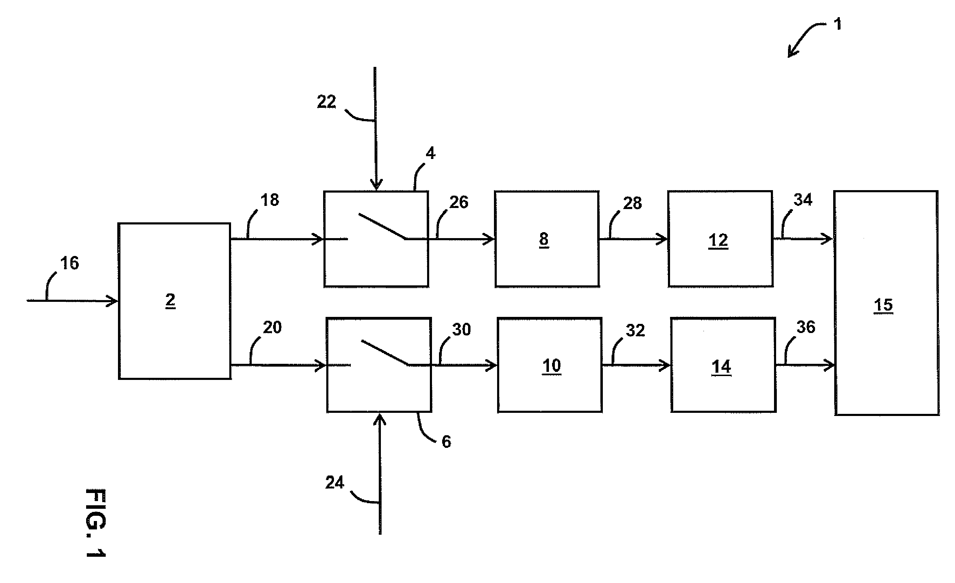

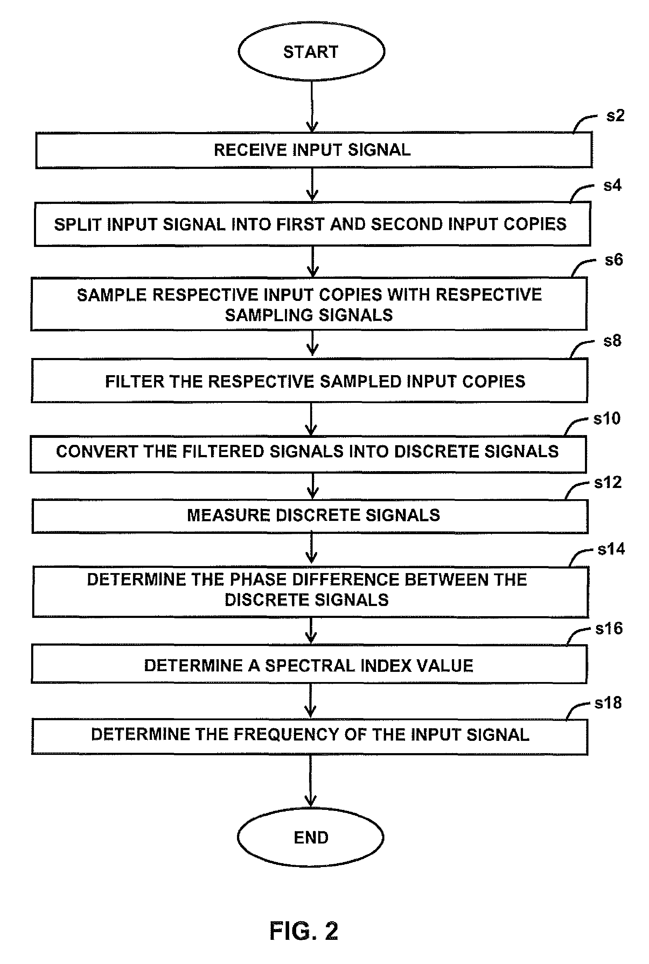

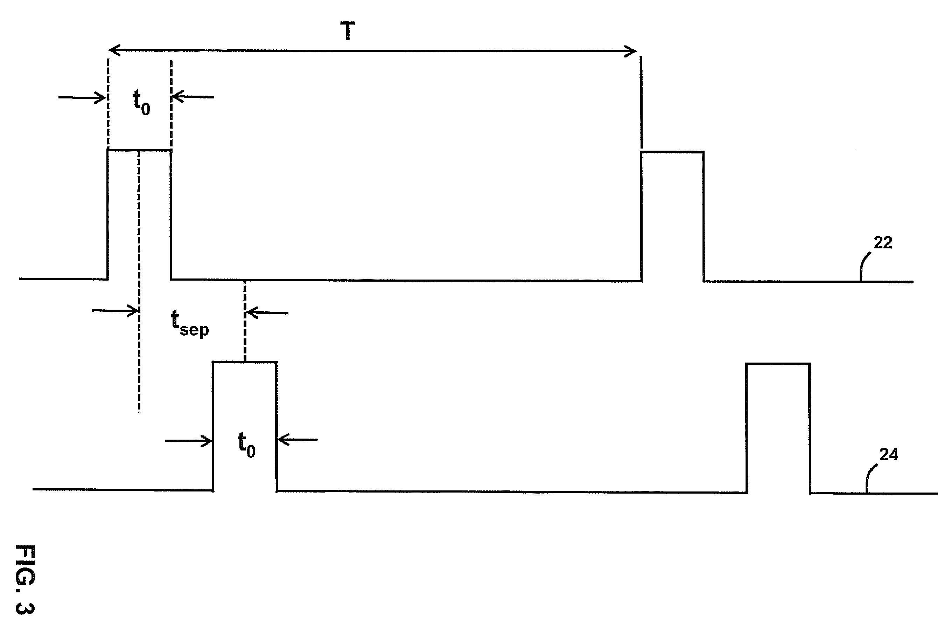

Figure 1 is a schematic block diagram of an apparatus used in an embodiment of an offset sampling process described below with reference to Figure 2. The apparatus shown in Figure 1 is hereinafter referred to as the "offset sampler 1". The term "offset" is used herein because the sampling signals used in the below described apparatus and process are offset in time relative to each other, as described in more detail later below with reference to Figure 3.

The offset sampler 1 comprises a splitter 2, a first sampler 4, a second sampler 6, a first Nyquist filter 8, a second Nyquist filter 10, a first analogue-to-digital converter (ADC) 12, a second ADC 14, and a processor 15.

The splitter 2 receives an input signal 16. The input signal 16 is a signal from a system being sampled by the offset sampler 1. In this embodiment, the input signal 16 is a continuous wave signal. The splitter 2 splits the input signal 16 into two substantially identical copies of the input signal 16, hereinafter called the "first input copy 18" and "the second input copy 20".

The first input copy 18 is sent from the splitter 2 to the first sampler 4.

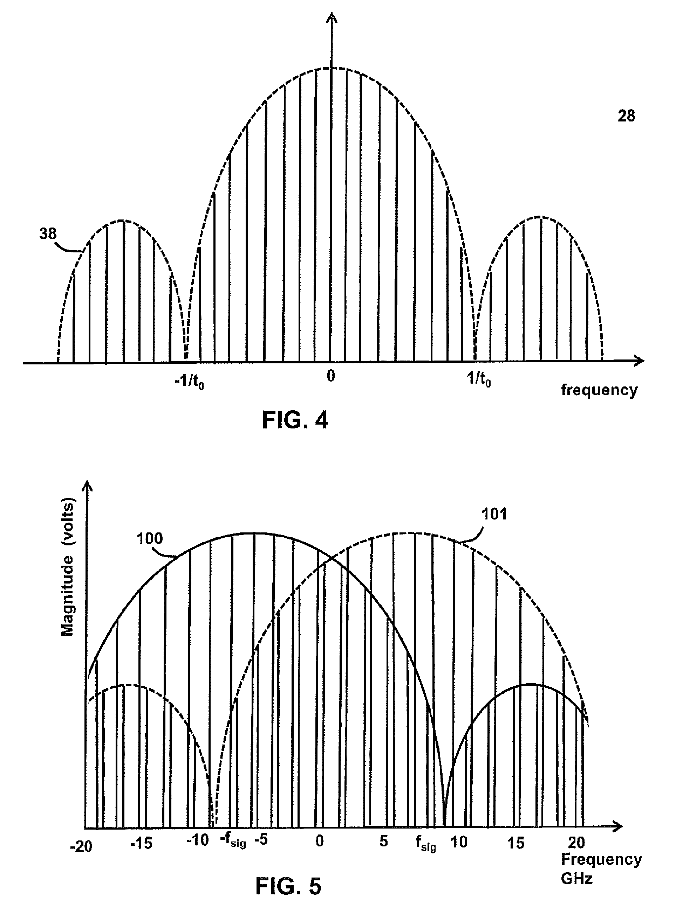

The first sampler 4 receives the first input copy 18 and a signal corresponding to a first sampling function, hereinafter referred to as the "first sampling signal 22". The first sampling signal 22 is described in more detail later below with reference to Figures 3 and 4. The first sampler 4 multiplies (in the time domain) the received first input copy 18 and first sampling signal 22 to produce a first output signal 26. The first output signal 26 is sent from the first sampler 4 to the first Nyquist filter 8.

The first Nyquist filter 8 filters the received first output signal 26 as described in more detail later below with reference to Figure 5. The filtered first output signal, hereinafter referred to as the "first filtered signal 28" is sent from the first Nyquist filter 8 to the first ADC 12.

The first ADC 12 converts the received continuous first filtered signal 28 into a discrete signal, hereinafter referred to as the "first discrete signal 34".

The first discrete signal 34 is sent to the processor 15 from the first ADC 12.

The second input copy 20 is sent from the splitter 2 to the second sampler 6.

The second sampler 6 receives the second input copy 20 and a signal corresponding to a second sampling function, hereinafter referred to as the "second sampling signal 24". The second sampling signal 24 is described in more detail later below with reference to Figures 3 and 4. The second sampler 6 multiplies (in the time domain) the received second input copy 20 and second sampling signal 24 to produce a second output signal 30. The second output signal 30 is sent from the second multiplier 6 to the second Nyquist filter 10.

The second Nyquist filter 10 filters the received second output signal 30 as described in more detail later below with reference to Figure 5. The filtered second output signal, hereinafter referred to as the "second filtered signal 32" is sent from the second Nyquist filter 10 to the second ADC 14.

The second ADC 14 converts the received continuous second filtered signal 32 into a discrete signal, hereinafter referred to as the "second discrete signal 36".

The second discrete signal 36 is sent to the processor 15 from the second ADC 14.

The first and second discrete signals 34, 36 are processed by the processor 15 to determine the frequency of the input signal 16.

Figure 2 is a process flow chart showing certain steps of an embodiment of an offset sampling process. The offset sampler 1 of Figure 1 is used to perform this offset sampling process.

At step s2, the input signal 16 is received at the splitter 2. The input signal 16 is a continuous wave signal from a system being sampled by the offset sampler 1. In this embodiment, for clarity and ease of understanding the frequency of the input signal $f_{sig}$ is 7.1 GHz. In this embodiment, we assume that the frequency of the input signal 16 is known. However, in other embodiments, this frequency is unknown, but may be determined by implementation of the offset sampling process using the offset sampler 1.

The input signal 16 is a real input. In this embodiment, the input signal 16 is given by the following formula:

$$Input\_signal = B \cdot \cos\left(\omega_{sig} \cdot t\right) = B \cdot \frac{e^{j \cdot \omega_{sig} \cdot t} + e^{-j \cdot \omega_{sig} \cdot t}}{2}$$

where: B is the maximum amplitude of the input signal; and

$\omega_{sig}$ is the angular frequency of the input signal.

The angular frequency of the input signal $\omega_{sig}$ is given by the following formula:

$$\omega_{sig} = 2\pi f_{sig} \ .$$

Thus, the input signal 16 is real and consists of two contra rotating vectors: $\dfrac{B}{2} \cdot e^{j \cdot \omega_{sig} \cdot t}$ and

$\dfrac{B}{2} \cdot e^{-j \cdot \omega_{sig} \cdot t}$ vectors: 2 and 2 .

At step s4, the splitter 2 splits the input signal 16 into the first input copy 18 and the second input copy 20. The first and second input copies 18, 20 are sent to the first and second multipliers 4, 6 respectively.

At step s6, the first input copy 18 is multiplied by the first sampling signal 22 by the first sampler 4. Also, the second input copy 20 is multiplied by the second sampling signal 24 by the second sampler 6.

Figure 3 is a schematic illustration (not to scale) showing the first sampling signal 22 and the second sampling signal 24 in the time domain. The sampling signals 22, 24 are shown on a common time axis.

The first sampling signal 22 comprises a pulse having a repetition period T, a pulse width to, and amplitude A.

In this embodiment, the repetition period is one nanosecond (T = 1 ns). Also, in this embodiment the pulse width is a sixteenth of a nanosecond (to = 62.5ps).

The second sampling signal 24 is substantially the same as the first sampling signal 22, but is shifted in time relative to the first sampling signal 22 by a separation time $t_{sep}$. In other words, the second sampling signal 24 comprises a pulse having a repetition period T, a pulse width to, and amplitude A. Also, the centre of a pulse of the second sampling signal 24 is separated in time by a separation time $t_{sep}$ from the centre of the corresponding pulse of the first sampling signal. The same characters are used herein to indicate the same characteristics of the first and second sampling signals 22, 24, i.e. T is used to indicate the repetition periods of the first and second sampling signals 22, 24, $t_0$ is used to indicate the pulse widths of the first and second sampling signals 22, 24, and A is used to indicate the amplitudes of the first and second sampling signals 22, 24.

In this embodiment, the separation time $t_{sep}$ is a sixteenth of a nanosecond ($t_{sep}$ = 62.5ps), i.e. $t_{sep}$ = to.

Figure 4 is a schematic illustration (not to scale) showing the first sampling signal 22 in the frequency domain. The second sampling signal 24 has the same frequency distribution as the first sampling signal 22.

The frequency spectrum of the first sampling signal 22 comprises a plurality of spectral lines. The spectral lines are spaced by a frequency amount known as the sampling frequency $f_s$. The relationship between the sampling frequency $f_s$, the repetition period T, and a wavelength of the first sampling signal $\omega_0$ is given by:

$$T = \frac{1}{f_s} = \frac{2 \cdot \pi}{\omega_0}$$

Thus, the sampling frequency is equal to one gigahertz ($f_s$ = 1 GHz).

The spectral lines have a $|\sin(x)/x|$ shaped distribution. An envelope for this $|\sin(x)/x|$ shaped distribution is shown in Figure 4 by a dotted line which is indicated by the reference numeral 38. The value for to effectively is used to define the bandwidth of interest as $1/t_0$ defines the first null in the $|\sin(x)/x|$ envelope. In this embodiment, to = $t_{sep}$ = 62.5ps and T is 1 ns. Thus, the $|\sin(x)/x|$ spectrum for the sampling function has a first null at 16GHz and the lines are spectral spaced by 1 GHz. The value of the repetition period T defines the sampling rate which has to be matched by the ADC.

The Fourier series of first sampling signal 22 is given by the formula:

$$f_1(t) = \sum_{n=-\infty}^{\infty} \alpha_n \cdot e^{j \cdot n \cdot \omega_o \cdot t}$$

where: $\alpha_n$ is given by the formula:

$$\alpha_n = A \cdot \frac{t_0}{T} \cdot \frac{\sin\left(\frac{n \cdot \omega_o \cdot t_0}{2}\right)}{\frac{n \cdot \omega_o \cdot t_0}{2}}$$

The Fourier series of the second sampling signal 24 is given by the following formula:

$$f_2(t) = \sum_{n=-\infty}^{\infty} \alpha_n \cdot e^{j \cdot n \cdot \omega_o \cdot (t - t_{sep})}$$

Since $T = \dfrac{1}{f_s} = \dfrac{2 \cdot \pi}{\omega_0}$ the Fourier series of the second sampling signal 24 may be expressed as:

$$f_2(t) = \sum_{n=-\infty}^{\infty} \alpha_n \cdot e^{j \cdot n \cdot \omega_o \cdot (t - t_{sep})} = \sum_{n=-\infty}^{\infty} \alpha_n \cdot e^{j(n \cdot \omega_o \cdot t)} \cdot e^{-j\left( n \cdot 2 \cdot \pi \cdot t_{sep}/T \right)}$$

In other words, the Fourier transform of the second sampling signal 24 is a linearly phase shifted version of Fourier series of first sampling signal 22. The term $e^{-j\left( n \cdot 2 \cdot \pi \cdot t_{sep}/T \right)}$ contains the phase shift $n \cdot 2 \cdot \pi \cdot t_{sep}/T$ incurred on the spectral line $n \cdot \omega_0$ for the second sampling signal 24 due to the delay relative to first sampling signal 22.

The product of the input signal 16 and the first sampling signal 22 is the first output signal 26, which is given by the following formula:

$$Output_1(t) = B \cdot \frac{e^{j \cdot \omega_{sig} \cdot t} + e^{-j \cdot \omega_{sig} \cdot t}}{2} \cdot \sum_{n=-\infty}^{\infty} \alpha_n \cdot e^{j \cdot n \cdot \omega_o \cdot t}$$

The product of the input signal 16 and the second sampling signal 24 is the second output signal 30, which is given by the following formula:

$$Output_2(t) = B \cdot \frac{e^{j \cdot \omega_{sig} \cdot t} + e^{-j \cdot \omega_{sig} \cdot t}}{2} \cdot \sum_{n=-\infty}^{\infty} \alpha_n \cdot e^{j \cdot n \cdot \omega_o \cdot t} \cdot e^{-j \cdot n \cdot 2 \cdot \pi \cdot t_{sep}/T}$$

An output signal 26, 30 is equal to the sampling spectrum shifted by $\pm \omega_{sig}$.

Figure 5 is a schematic illustration (not to scale) of the frequency spectrum of an output signal 26, 30. The frequency of the input signal $f_{sig}$ is 7.1GHZ, thus the output spectrum has peaks at $\pm 7.1$ GHz. For clarity, an envelope of the product of a sampling signal and the -7.1 GHz peak of the input signal is shown in Figure 5 as a solid line indicated by the reference numeral 100. Also, for clarity an envelope of the product of a sampling signal and the +7.1 GHz peak of the input signal is shown in Figure 5 as a dotted line indicated by the reference numeral 101.

As shown schematically in Figure 5, a pair of spectral lines is present at each of the following output locations: 0GHz, 1 GHz, 2 GHz, 3GHz, ..., nGHz. The spectral lines of each respective spectral line pair are positioned either side of the respective output locations. Because the frequency of the input signal $f_{sig}$ is 7.1GHz, spectral lines appear at $\pm 100$MHz, $\pm 900$MHz, $\pm 1.1$ GHz, $\pm 1.9$ GHz, $\pm 2.1$GHz, $\pm 2.9$GHz etc. In this embodiment, the outputs are generated at a 1 GHz data rate (because T = 1 ns).

At step s8, the first output signal 26 is filtered by the first Nyquist filter 8 to produce the first filtered signal 28. Also, the second output signal 30 is filtered by the second Nyquist filter 10 to produce the second filtered signal 32.

In the offset sampler 1, the Nyquist filters 8, 10 perform multiple tasks, namely: sampler product filtering, pulse interpolation filtering, and ADC anti-aliasing filtering. The Nyquist filters 8, 10 ensure that the signals the ADCs 12, 14 are to digitise (at step s10 below) are signals within the Nyquist capabilities of the ADCs 12, 14.

The Nyquist frequency is equal to half of the frequency of a sampling signal, i.e. in this embodiment the Nyquist frequency is $f_s/2 = 500$MHz.

In the description of this embodiment, to simplify the explanation, the Nyquist filters 8, 10 are treated as idealised or so-called "brick wall filters" that are effective at the Nyquist frequency of 500MHz, in other words, the Nyquist filters 8, 10 block all frequencies above 500 MHz and let all frequencies between 0MHz and 500MHz pass.

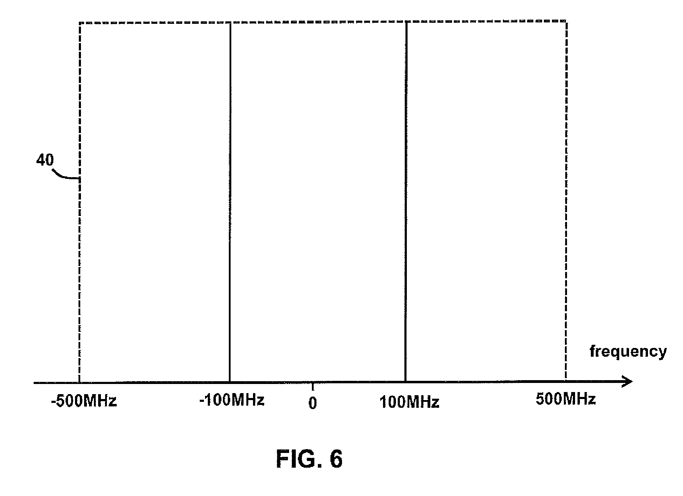

Figure 6 is a schematic illustration (not to scale) of the frequency spectrum of a respective first or second output signal 26, 30 after filtering using a respective first or second Nyquist filter 8, 10.

The frequencies not blocked by a Nyquist filters are those between -500MHz and 500MHz. This frequency band is indicated in Figure 6 by dotted lines and is hereinafter referred to as the "Nyquist zone 40".

The only two spectral or alias lines that lie within the Nyquist zone 40 are positioned at $\pm 100$MHz.

At step s10, the first ADC 12 is used to digitise the first filtered signal 28 to produce the first discrete signal 34. Also, the second ADC 14 is used to digitise the second filtered signal 32 to produce the second discrete signal 36.

Thus, in this embodiment the ADCs 12, 14 are 1 GHz ADCs.

The first discrete signal 34 and the second discrete signal 36 are sent to the processor 15.

At step s12, the first and second discrete signals 34, 36 are measured at the processor 15. In this embodiment, signals are measured to be $\pm 100$MHz.

To obtain frequency information from the ADC samples it is necessary to transform from the time domain to the frequency domain, for example by performing a Fast Fourier Transform (FFT). For a real FFT the information shown in the negative part of the frequency spectrum is a mirror of that in the positive half of the frequency spectrum. Thus, usually the negative portion of the spectrum is suppressed for display purposes but is retained here for clarity and ease of understanding.

As mentioned above, the input signal 16 consists of two contra rotating vectors: $\dfrac{B}{2} \cdot e^{j \cdot \omega_{sig} \cdot t}$ and

$\dfrac{B}{2} \cdot e^{-j \cdot \omega_{sig} \cdot t}$. The measured 100MHz spectral line is generated by the multiplication of the vector

$\dfrac{B}{2} \cdot e^{j \cdot \omega_{sig} \cdot t}$ by $\alpha_n e^{jn\omega_0 t}$ (where n=-7 in this embodiment). Also, the measured -100MHz spectral line is generated by the multiplication of the vector $\dfrac{B}{2} \cdot e^{-j \cdot \omega_{sig} \cdot t}$ by $\alpha_n e^{jn\omega_0 t}$ (where n=7 in this embodiment). All other products fall outside the Nyquist zone 40.

The frequency/phase of the 100MHz spectral line (n = -7) of this embodiment at the first ADC 12 is given by:

$$Output_{1(100MHz)} = \alpha_{-7} e^{j \cdot (-7 \cdot \omega_0 + \omega_{sig}) \cdot t} = \alpha_{-7} e^{j \cdot \omega_{100MHz} \cdot t}$$

where: $\omega_{100MHZ}$, is the angular frequency of the 100MHz spectral line.

Also, the frequency/phase of the 100MHz spectral line (n = -7) of this embodiment at the second ADC 14 is given by:

$$Output_{2(100MHz)} = \alpha_n e^{j \cdot ((n \cdot \omega_0 + \omega_{sig}) \cdot t - 2 \cdot n \cdot \pi \frac{t_{sep}}{T})} = \alpha_{-7} e^{j \cdot (\omega_{100MHz} \cdot t + 7\pi/8)}$$

At step s12, the phase difference between the first and second discrete signals 34, 36 is determined by the processor 15.

In this embodiment, this phase difference is given by the following formula:

$$Exponential\_Phase\_diff = \frac{Output_{2(100MHz)}}{Output_{1(100MHz)}} = \frac{\beta \cdot \alpha_n e^{j \cdot ((n \cdot \omega_0 + \omega_{sig}) \cdot t - 2 \cdot n \cdot \pi \frac{t_{sep}}{T})}}{\beta \cdot \alpha_n e^{j \cdot (n \cdot \omega_0 + \omega_{sig}) \cdot t}}$$

Thus, for n = -7 the above formula becomes:

$$Exponential\_Phase\_diff = \frac{Output_{2(100MHz)}}{Output_{1(100MHz)}} = \frac{\alpha_{-7} e^{j \cdot (\omega_{100MHz} \cdot t + 7\pi / 8)}}{\alpha_{-7} e^{j \cdot \omega_{100MHz} \cdot t}} = e^{j \cdot 7\pi / 8}$$

For the 100MHz spectral line, the angular phase difference between $Output_{1(100MHZ)}$ and $Output_{2(100MHZ)}$ is $-n \cdot 2 \cdot \pi \cdot \frac{t_{sep}}{T}$  radians with n = -7, i.e.  $\frac{7\pi}{8}$  radians. radians.

At step s16, a spectral index value is determined by the processor 15. In this embodiment, the spectral index is defined as the measured phase difference between the respective signals at the respective first and second ADCs 12, 14 divided by the phase step for the first spectral line (i.e. the spectral line n = 1). In other words:

$$Spectral\_index = \frac{Phase\_difference}{Phase\_step\_for\_first\_indexed\_spectral\_line}$$

In this embodiment, the phase step for the first indexed spectral line is:

$$-2 \cdot \pi \cdot \frac{t_{sep}}{T} = -2 \cdot \pi \cdot \frac{1}{16} = -\frac{\pi}{8} .$$

Thus, in this embodiment the spectral index for the 100MHz spectral line is:

$$\frac{-7\pi / 8}{\pi / 8} = -7 .$$

At step s18, the frequency of the input signal $f_{sig}$ (which in this embodiment is known, but in real world application may be unknown) is determined by the processor 15. In this embodiment, the frequency of the input signal $f_{sig}$ is determined using the following formula:

$$f_{sig} = -1 * Spectral\_index * f_s + Measured\_frequency$$

where Measured_frequency is the frequency measured at the ADCs 12, 14.
In this embodiment, $f_{sig}$ =-1*-7*1Ghz+100Hz=7.1GHz.
Thus, an offset sampling process that advantageously correctly determines the frequency of an input signal

$f_{sig}$ is provided.

An advantage of multiplying the input signal 16 by a sampling waveform, e.g. a pulse signal having a $|\sin(x)/x|$ shaped envelope (i.e. the first or second sampling signal 22, 24), is that the input signal 16 is advantageously mixed down into the Nyquist zone of the ADCs 12, 14. In this embodiment, the 7.1 GHz input signal 16 is mixed down such that it is represented by the spectral lines at $\pm$100MHz shown in Figure 6, which are within the $\pm$500MHz Nyquist zones of the ADCs 12, 14. Thus, the ADCs advantageously tend to be able to be used to sample a signal having a frequency outside the Nyquist zone of the ADCs. However, the frequencies outside the Nyquist zone of the ADCs may be ambiguous.

A further advantage of provided by the present invention is that the above mentioned ambiguity tends to be resolved by using the offset first and second sampling signals 22, 24. The offset between the pulses of the first and second sampling signals 22, 24 produces a phase difference between the first and second discrete signals 34, 36 produced by the first and second ADCs 12, 14 respectively. This phase difference is used by the processor to determine a spectral index value which advantageously identifies the original frequency of the input signal 16.

In other words, the invention advantageously mixes down a frequency band of interest into the Nyquist zones of the ADCs, and advantageously exploits offset sampling to resolve the ambiguity that arises when this mixing down is performed.

An advantage of this approach is that a wide, sparsely populated bandwidth is capable of being monitored with a minimum of hardware, i.e. less hardware than is needed conventionally.

A further advantage of the above described technique is that it tends to be able to be implemented in electronic surveillance measures (ESM) systems at a significantly lower price than current technology.

It should be noted that certain of the process steps depicted in the flowchart of Figure 2 and described above may be omitted or such process steps may be performed in differing order to that presented above and shown in Figure 2. Furthermore, although all the process steps have, for convenience and ease of understanding, been depicted as discrete temporally-sequential steps, nevertheless some of the process steps may in fact be performed simultaneously or at least overlapping to some extent temporally.

Apparatus, including the processor 15, for implementing the above arrangement, and performing the method steps to be described above, may be provided in part or completely by configuring or adapting any suitable apparatus, for example one or more computers or other processing apparatus or processors, and/or providing additional modules. The apparatus may comprise a computer, a network of computers, or one or more processors, for implementing instructions and using data, including instructions and data in the form of a computer program or plurality of computer programs stored in or on a machine readable storage medium such as computer memory, a computer disk, ROM, PROM etc., or any combination of these or other storage media. The apparatus may, for example, include one or more spectrum analysers to determine one or more of the frequencies, and/or one or more Vector Voltmeters to measure a phase.

In other embodiments, an optional additional step may be performed as follows. Using the known shape of the frequency spectrum of the sampling signals 22, 24, the known spectral line spacing, which can be determined from the shape of the sampling signal i.e. the known values of to and T in this embodiment), and the determined value of the original input signal frequency $f_{sig}$, the original amplitude of the input signal B can be corrected to compensate for weighting loss (e.g. the $|\sin(x)/x|$ weighting loss). This advantageously tends to provide increased accuracy in estimations of the amplitude of the input signal.

In other words, the magnitude of the spectral lines is affected by which harmonic of the sampling spectrum is used to mix the signal into the ADCs' Nyquist bandwidths. Knowing the $|\sin(x)/x|$ amplitude distribution for any given sampling pulse width and the repetition rate, the amplitudes can also be adjusted to compensate for mixing losses. Thus, both corrected amplitude and frequency information is advantageously provided.

The maximum phase that can be measured is less than $\pi$. This is because the phase becomes ambiguous, i.e. phases of $+\pi$ and $-\pi$ tend not to be able to be distinguished. Thus, in the above embodiment the maximum spectral line that could be used was n = 7 which, with the Nyquist filter bandwidth of 500MHz, means that a maximum input signal of 7.5 GHz may be correctly determined. Thus, using two ADCs it is possible to resolve the input signal over fifteen Nyquist zones. By using input band defining filters for an input signal of 7.5 GHz it is possible to prevent any ambiguities due to higher frequencies.

The magnitude of the phase step can advantageously be made smaller by reducing $t_{sep}$ such that a greater number of Nyquist zones can be instrumented before the ambiguity arises. There is a trade off here as the measured phase may be noisy in some systems and therefore the spectral line index will need to be able to cope with this noise. In other embodiments of the invention, a spectral index according to the following formula is used which advantageously tends to alleviate the effects of this noise:

$$\text{Spectral\_index} = \text{Round}\left[\frac{\text{Phase\_difference}}{\text{Phase\_step\_for\_first\_indexed\_spectral\_line}}\right]$$

where the Round[X] is the value of X rounded to the nearest integer. Using this spectral index, an error up to half of phase step for the first indexed spectral line can advantageously be tolerated

The offset sampler enables multiple Nyquist zones to be monitored with only two ADCs and can locate CW lines at the correct frequency. If multiple input frequencies alias to the same frequency resolution bin within the ADCs' Nyquist bands, it is advantageously possible to distinguish between the frequencies aliasing to the same frequency resolution bin by changing the ADC clock frequency.

In the above embodiments, the offset sampler described above with reference to Figure 1 is used to perform the offset sampling process described with reference to Figure 2. However, in other embodiments the offset sampling process may be performed with a different apparatus that is configured to perform the offset sampling process.

In the above embodiments, the frequency of the input signal $f_{sig}$ is a known value 7.1 GHz. However, in other embodiments the input signal may have a different frequency and may be either known or unknown.

In the above embodiments, for a set of continuous tones distributed over multiple Nyquist zones, the original input frequency can advantageously be determined. In other embodiments, the input signal may be a different type of signal, for example a pulse or an intermittent continuous wave signal. Frequency and/or amplitude information tends to be able to be determined in the same way as that described above for the continuous wave input signal. The "on" duration for a signal may need to allow sufficient signal to noise, after processing, for the phase to be measured at each ADC output.

In the above embodiments, the sampling signals comprise a pulse having a repetition period T = 1 ns, a pulse width to = 62.5ps. However, in other embodiments, sampling signals having different repetition periods and/or pulse widths may be used. Also, in other embodiments sampling signals having waveforms of any shape may be used. In particular, in other embodiments any waveforms that provided a sampling function and enable the phase difference between two or more outputs to be used to determine the input frequency may be used.

In the above embodiments, the separation time $t_{sep}$ is a sixteenth of a nanosecond ($t_{sep}$ = 62.5ps). However, in other embodiments the separation time $t_{sep}$ may be a different appropriate value, and may or may not be equal to the pulse width to.

In the description of the above embodiments, to clarify the description, the Nyquist filters are treated as idealised filters (so-called "brick wall filters") that are effective at the Nyquist frequency of 500MHz (i.e. the Nyquist filters block all frequencies above 500 MHz and let all frequencies between 0MHz and 500MHz pass). Thus, the Nyquist filters are anti-aliasing filters. However, in other embodiments one or more of the Nyquist filters may be a different appropriate type of filter and/or may be effective over a different appropriate frequency range to provide the anti-aliasing function.

**Claims**

1. A method of performing sampling, the method comprising:

    sampling an input signal (16) using a first sampling signal (22) to provide a first sampled signal (26);
    sampling the input signal (16) using a second sampling signal (24) to provide a second sampled signal (30);
    measuring a frequency of at least one of the first sampled signal (26) and the second sampled signal (30);
    measuring a phase difference between the first sampled signal (26) and the second sampled signal (30); and
    determining a frequency of the input signal (16) using the measured frequency and the measured phase difference; wherein
    the second sampling signal (24) has substantially equal frequency to the first sampling signal (22); and
    a waveform of the second sampling signal (24) is shifted in time with respect to a waveform of the first sampling signal (22).

2. A method according to claim 1, wherein the measured frequency of at least one of the first sampled signal (26) and the second sampled signal (30) is a measured alias frequency of the true frequency of at least one of the first sampled signal (26) and the second sampled signal (30).

3. A method according to claim 1 or claim 2, wherein the waveform of the second sampling signal (24) is substantially equal to the waveform of the first sampling signal (22).

4. A method according to any of claims 1 to 3, further comprising the step of determining the amplitude of the input signal (16) using the waveforms and magnitudes of the sampling signals (22, 24), values of the frequency of the waveforms of the sampling signals (22, 24), and the determined input signal frequency.

5. A method according to any of claims 1 to 4, wherein the step of measuring a frequency of at least one of the first sampled signal (26) and the second sampled signal (30) is performed within a Nyquist zone of an analogue-to-digital converter (12, 14).

6. A method according to any of claims 1 to 5, wherein the step of determining a frequency of the input signal (16) further comprises using a value of a frequency of a sampling signal (22, 24), a value of the time shift that the second sampling signal (24) is shifted in time relative to the first sampling signal (22), and a value of the time period of a sampling signal (22, 24).

7. A method according to claim 6, wherein the frequency of the input signal (16) is determined using the following formula:

$$f_{sig} = -1 * Spectral\_index * f_s + Measured\_frequency$$

where: $f_{sig}$ is the frequency of the input signal (16);
$f_s$ is the frequency of a sampling signal (22, 24);
Measured_frequency is a measured value of a frequency of at least one of the first sampled signal (26) and the second sampled signal (30); and

$$Spectral\_index = \frac{Phase\_difference}{Phase\_step\_for\_first\_indexed\_spectral\_line}$$

where: Phase_difference is the measured phase difference; and
Phase_step_for_first_indexed_spectral_line is a value of a phase step of a first spectral line in a frequency spectrum of the sampling signals (22, 24).

8. A method according to claim 6, wherein the frequency of the input signal (16) is determined using the following formula:

$$f_{sig} = -1 * Spectral\_index * f_s + Measured\_frequency$$

where: $f_{sig}$ is the frequency of the input signal (16);
$f_s$ is the frequency of a sampling signal (22, 24);
Measured_frequency is a measured value of a frequency of at least one of the first sampled signal (26) and the second sampled signal (30); and

$$Spectral\_index = Round\left[\frac{Phase\_difference}{Phase\_step\_for\_first\_indexed\_spectral\_line}\right]$$

where: Phase_difference is the measured phase difference; and
Phase_step_for_first_indexed_spectral_line is a value of a phase step of a first spectral line in a frequency spectrum of the sampling signals (22, 24); and
Round[X] is the value of X rounded to the nearest integer.

**9.** A method according to claim 7 or 8, wherein:

$$\text{Phase\_step\_for\_first\_indexed\_spectral\_line} = -2 \cdot \pi \cdot \frac{t_{sep}}{T}$$

where: $t_{sep}$ is a value of the time shift that the waveform of the second sampling signal (24) is shifted by with respect to the waveform of the first sampling signal (22); and
T is a value of a time period of a sampling signal (22, 24).

**10.** A method according to any of claims 1 to 9, wherein the step of measuring a frequency of at least one of the first sampled signal (26) and the second sampled signal (30) comprises:

filtering the first sampled signal (26) such that it lies within a Nyquist zone of a first analogue-to-digital converter (12);
using the first analogue-to-digital converter (12), converting to a discrete signal the filtered first sampled signal (28);
filtering the second sampled signal (30) such that it lies within a Nyquist zone of a second analogue-to-digital converter (14);
using the second analogue-to-digital converter (14), converting to a discrete signal the filtered second sampled signal (32); and
measuring a value of the frequency of signal converted by the first analogue-to-digital converter (12) and/or a value of the frequency of signal converted by the second analogue-to-digital converter (14).

**11.** An apparatus for performing sampling, the apparatus comprising:

a first sampler (4) adapted to sample an input signal (16) using a first sampling signal (22) to provide a first sampled signal (26);
a second sampler (6) adapted to sample the input signal (16) using a second sampling signal (24) to provide a second sampled signal (30);
means for measuring a frequency of at least one of the first sampled signal (26) and the second sampled signal (30);
means for measuring a phase difference between the first sampled signal (26) and the second sampled signal (30); and
a processor (15) adapted to determine a frequency of the input signal (16) using the measured frequency and the measured phase difference; wherein
the second sampling signal (24) has substantially equal frequency to the first sampling signal (22); and
a waveform of the second sampling signal (24) is shifted in time with respect to a waveform of the first sampling signal (22).

**12.** An apparatus according to claim 11, wherein the processor (15) is adapted to determine a frequency of the input signal (16) using the measured frequency, the measured phase difference, a value of a frequency of a sampling signal (22, 24), a value of the time shift that the second sampling signal (24) is shifted in time relative to the first sampling signal (22), and a value of the time period of a sampling signal (22, 24).

**13.** An apparatus according to claims 11 or 12, further comprising:

a first filter (8);
a second filter (10);
a first analogue-to-digital converter (12); and
a second analogue-to-digital converter (14); wherein
the first filter (8) is arranged to filter the first sampled signal (26) such that it lies within a Nyquist zone of the first analogue-to-digital converter (12);
the first analogue-to-digital converter (12) is arranged to convert to a discrete signal the filtered first sampled signal (28);
the second filter (10) is arranged to filter the second sampled signal (30) such that it lies within a Nyquist zone of the second analogue-to-digital converter (14);

the second analogue-to-digital converter (14) is arranged to convert to a discrete signal the filtered second sampled signal (32); and

the means for measuring a frequency of at least one of the first sampled signal (26) and the second sampled signal (30) is adapted to measure a value of the frequency of signal converted by the first analogue-to-digital converter (12) and/or a value of the frequency of signal converted by the second analogue-to-digital converter (14).

14. A computer program or plurality of computer programs arranged such that when executed by a computer system it/they cause the computer system to operate in accordance with the method of any of claims 1 to 9.

15. A machine readable storage medium storing a computer program or at least one of the plurality of computer programs according to claim 14.

FIG. 1

START

s2
RECEIVE INPUT SIGNAL

s4
SPLIT INPUT SIGNAL INTO FIRST AND SECOND INPUT COPIES

s6
SAMPLE RESPECTIVE INPUT COPIES WITH RESPECTIVE
SAMPLING SIGNALS

s8
FILTER THE RESPECTIVE SAMPLED INPUT COPIES

s10
CONVERT THE FILTERED SIGNALS INTO DISCRETE SIGNALS

s12
MEASURE DISCRETE SIGNALS

s14
DETERMINE THE PHASE DIFFERENCE BETWEEN THE
DISCRETE SIGNALS

s16
DETERMINE A SPECTRAL INDEX VALUE

s18
DETERMINE THE FREQUENCY OF THE INPUT SIGNAL

END

FIG. 2

FIG. 3

28

38

-1/t₀    0    1/t₀

frequency

**FIG. 4**

101

100

Magnitude (volts)

-20    -15    -10    -f_sig    -5    0    5    f_sig    10    15    20

Frequency GHz

**FIG. 5**

**FIG. 6**

Europäisches
Patentamt

European
Patent Office

Office européen
des brevets

**EUROPEAN SEARCH REPORT**

Application Number

EP 10 27 5026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 5 294 926 A (CORCORAN JOHN J [US]) 15 March 1994 (1994-03-15) * figure 2 * | 1-15 | INV. H03M1/12 |
| Y | WO 2008/082835 A1 (TERADYNE INC [US]; XU FANG [US]) 10 July 2008 (2008-07-10) * paragraphs [0017], [0018]; figures 2,5 * | 1-15 | |
| Y | WO 2004/004130 A2 (BAE SYSTEMS PLC [GB]; WOOD JOHN MICHAEL [GB]; COOTE NIGEL CHARLES TRUE) 8 January 2004 (2004-01-08) * claim 1 * | 1,10 | |
| Y | US 4 763 105 A (JENQ YIH-CHYUN [US]) 9 August 1988 (1988-08-09) * figures 1,9 * | 1-15 | |
| Y | WO 2008/039528 A2 (TERADYNE INC [US]; XU FANG [US]) 3 April 2008 (2008-04-03) * figures 2,6 * | 1-15 | TECHNICAL FIELDS SEARCHED (IPC) |
| Y | US 6 269 317 B1 (SCHACHNER JOSEPH M [US] ET AL) 31 July 2001 (2001-07-31) * figure 1 * | 1-15 | H03M |
| Y | US 5 099 243 A (TSUI JAMES B Y [US] ET AL) 24 March 1992 (1992-03-24) * figure 1 * | 1-15 | |
| A | EP 1 720 259 A1 (AGILENT TECHNOLOGIES INC [US]) 8 November 2006 (2006-11-08) * figure 1 * | 1-15 | |
| A | WO 99/30428 A1 (QUALCOMM INC [US]) 17 June 1999 (1999-06-17) * figure 6 * | 1-15 | |

The present search report has been drawn up for all claims

| Place of search | Date of completion of the search | Examiner |
|---|---|---|
| Munich | 23 July 2010 | Müller, Uta |

EPO FORM 1503 03.82 (P04C01)

**ANNEX TO THE EUROPEAN SEARCH REPORT
ON EUROPEAN PATENT APPLICATION NO.** EP 10 27 5026

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-2010

| Patent document cited in search report | | Publication date | Patent family member(s) | | Publication date |
|---|---|---|---|---|---|
| US 5294926 | A | 15-03-1994 | NONE | | |
| WO 2008082835 | A1 | 10-07-2008 | US 2008169949 | A1 | 17-07-2008 |
| WO 2004004130 | A2 | 08-01-2004 | AT 403274 | T | 15-08-2008 |
| | | | AU 2003253088 | A1 | 19-01-2004 |
| | | | CA 2490577 | A1 | 08-01-2004 |
| | | | EP 1522146 | A2 | 13-04-2005 |
| | | | ES 2307978 | T3 | 01-12-2008 |
| | | | JP 4064963 | B2 | 19-03-2008 |
| | | | JP 2005531235 | T | 13-10-2005 |
| | | | US 2005219091 | A1 | 06-10-2005 |
| US 4763105 | A | 09-08-1988 | DE 3885166 | D1 | 02-12-1993 |
| | | | DE 3885166 | T2 | 26-05-1994 |
| | | | EP 0298618 | A2 | 11-01-1989 |
| | | | JP 1035621 | A | 06-02-1989 |
| | | | JP 1755745 | C | 23-04-1993 |
| | | | JP 4047330 | B | 03-08-1992 |
| WO 2008039528 | A2 | 03-04-2008 | US 2008079623 | A1 | 03-04-2008 |
| US 6269317 | B1 | 31-07-2001 | NONE | | |
| US 5099243 | A | 24-03-1992 | NONE | | |
| EP 1720259 | A1 | 08-11-2006 | CN 1859009 | A | 08-11-2006 |
| | | | JP 2006313162 | A | 16-11-2006 |
| | | | US 2006250288 | A1 | 09-11-2006 |
| WO 9930428 | A1 | 17-06-1999 | AU 746148 | B2 | 18-04-2002 |
| | | | AU 1717899 | A | 28-06-1999 |
| | | | BR 9813414 | A | 10-10-2000 |
| | | | CA 2313139 | A1 | 17-06-1999 |
| | | | CN 1281597 | A | 24-01-2001 |
| | | | DE 69839192 | T2 | 26-02-2009 |
| | | | DK 1040587 | T3 | 02-06-2008 |
| | | | EP 1040587 | A1 | 04-10-2000 |
| | | | ES 2301217 | T3 | 16-06-2008 |
| | | | JP 2001526487 | T | 18-12-2001 |
| | | | KR 100712412 | B1 | 27-04-2007 |
| | | | MX PA00005773 | A | 07-11-2002 |
| | | | US 6005506 | A | 21-12-1999 |
| | | | ZA 9811125 | A | 10-10-2000 |

EPO FORM P0459

For more details about this annex : see Official Journal of the European Patent Office, No. 12/82